# EUROPEAN PATENT SPECIFICATION

(11) **EP 4 084 004 B1**
(45) Date of publication and mention of the grant of the patent: **13.12.2023**
(21) Application number: 22169889.7
(22) Date of filing: 26.04.2022
(51) Int. Cl.: G10L 21/0316, G10L 21/0364, A62B 18/08, H03G 5/16

(54) **COMPENSATION FOR FACE COVERINGS IN CAPTURED AUDIO**
KOMPENSATION VON GESICHTSABDECKUNGEN IN AUFGENOMMENEN AUDIOSIGNALEN
COMPENSATION POUR LES COUVRE-VISAGES DANS LES AUDIO CAPTURÉS

(30) Priority: 26.04.2021 US 202117240425
(43) Date of publication of application: 02.11.2022
(73) Proprietor: Avaya Management L.P., Durham NC 27713 (US)
(72) Inventor: LYNCH, John C, Belleville, K8N 0J5 (CA); ARAUJO, Miguel De, Belleville, K8N 4N2 (CA); KALKAT, Gurbinder Singh, Belleville, K8P 5G2 (CA); YEE, Eugene Pung-Gin, Thornton, 80602 (US); MCARTHUR, Christopher Bruce, Belleville, K8N 4Z2 (CA)
(74) Representative: Page White Farrer

(56) References cited:
- EP-A2- 2 950 890
- US-A1- 2022 199 103
- COREY RYAN M ET AL: "Acoustic effects of medical, cloth, and transparent face masks on speech signalsa)", THE JOURNAL OF THE ACOUSTICAL SOCIETY OF AMERICA, AMERICAN INSTITUTE OF PHYSICS, 2 HUNTINGTON QUADRANGLE, MELVILLE, NY 11747, vol. 148, no. 4, 27 October 2020 (2020-10-27), pages 2371-2375, XP012253442, ISSN: 0001-4966, DOI: 10.1121/10.0002279 [retrieved on 2020-10-27]
- TOSCANO JOSEPH C. ET AL: "Effects of face masks on speech recognition in multi-talker babble noise", PLOS ONE, [Online] vol. 16, no. 2, 24 February 2021 (2021-02-24), page e0246842, XP055959164, DOI: 10.1371/journal.pone.0246842 Internet Retrieved from the Internet: URL:https://doi.org/10.1371/journal.pone.0 246842> [retrieved on 2022-09-09]

## Description

### TECHNICAL BACKGROUND

Globally, face coverings, such as face masks positioned over a peoples' mouths, are used extensively for protection from the spread of viruses and other infections during a global pandemic. In normal (non-pandemic) times, face coverings are still used in many situations to protect a person and others. For instance, face coverings are common in medical environments and in other workplaces to protect from harmful airborne contaminants (e.g., hazardous dust particles). Face coverings tend to block portions of the audio spoken by a wearer making them more difficult to understand. The blocked components of speech are not linear and cannot be recovered by simply increasing the speech level by normal means, such as talking louder, turning up the volume of a voice or video call, or moving closer in face-to-face conversations.

A speech enhancement method that compensates for the non-linear attenuation characteristics of a respiratory mask is disclosed in the US patent application publication US2014/0216447, "Respiratory Mask Speech Enhancement Apparatus and Method", by R. Kihlberg, 07.08.2014.

### SUMMARY

The technology disclosed herein enables compensation for attenuation caused by face coverings in captured audio. There is provided a method according to claim 1.

In some embodiments, the method includes, after adjusting the frequencies, transmitting the audio over a communication session between the user system and another user system.

In some embodiments, adjusting the amplitudes of the frequencies includes amplifying the frequencies based on attenuation to the frequencies caused by the face covering. The attenuation may indicate that a first set of the frequencies should be amplified by a first amount and a second set of the frequencies should be amplified by a second amount.

In some embodiments, the method includes receiving reference audio that includes reference speech from the user while the mouth is not covered by the face covering. In those embodiments, the method may include comparing the reference audio to the audio to determine an amount in which the frequencies have been attenuated by the face covering. Similarly, in those embodiments, the method may include receiving training audio that includes training speech from the user while the mouth is covered by the face covering, wherein the training speech and the reference speech include words spoken by the user from a same script, and comparing the reference audio to the training audio to determine an amount in which the frequencies have been attenuated by the face covering.

In some embodiments, determining that the face covering is positioned to cover the mouth of the user includes receiving video of the user and using face recognition to determine that the mouth is covered.

In some embodiments, adjusting the amplitudes of the frequencies includes accessing a profile for the face covering that indicates the frequencies and amounts in which the amplitudes should be adjusted.

In some embodiments, the method includes receiving video of the user and replacing the face covering in the video with a synthesized mouth for the user.

In another embodiment, an apparatus is provided according to claim 6.

### BRIEF DESCRIPTION OF THE DRAWINGS

Figure 1 illustrates an implementation for compensating for face coverings in captured audio.
Figure 2 illustrates an operation to compensate for face coverings in captured audio.
Figure 3 illustrates an operational scenario for compensating for face coverings in captured audio.
Figure 4 illustrates an implementation for compensating for face coverings in captured audio.
Figure 5 illustrates an operational scenario for compensating for face coverings in captured audio.
Figure 6 illustrates a speech frequency spectrum graph for compensating for face coverings in captured audio.
Figure 7 illustrates an operational scenario for compensating for face coverings in captured video.
Figure 8 illustrates a computing architecture for compensating for face coverings in captured audio.

### DETAILED DESCRIPTION

The examples provided herein enable compensation for the effects of wearing a face covering (e.g., mask, shield, etc.) when speaking into a user system. Since the effects of a face covering are non-linear (i.e., all vocal frequencies are not affected the same amount), simply increasing the volume of speech captured from a user wearing a face covering will not account for those effects. Rather, the amplitude of frequencies in the speech will be increased across the board even for frequencies in the speech that are not affected (or are negligibly affected) by the face covering. The compensation described below accounts for the non-linear effects by selectively amplifying the frequencies in speech based on how much respective frequencies are affected by a face covering. Advantageously, frequencies that are not affected by the face covering will not be amplified while frequencies that are affected will be amplified an amount corresponding to how much those frequencies were attenuated by the face covering.

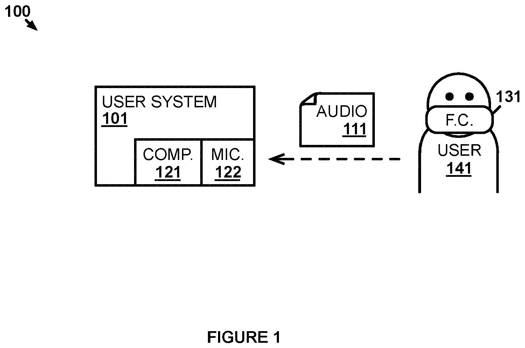

Figure 1 illustrates implementation 100 for compensating for face coverings in captured audio. Implementation 100 includes user system 101 having compensator 121 and microphone 122. User system 101 is operated by user 141. User system 101 may be a telephone, tablet computer, laptop computer, desktop computer, conference room system, or some other type of computing system. Compensator 121 may be implemented as software instructions executed by user system 101 (e.g., may be a component of a communications client application or other application that captures audio) or as hardware processing circuitry. Microphone 122 captures sound and provides audio representing that sound in a signal to user system 101. Microphone 122 may be incorporated into user system 101, may be connected via a wired connection to user system 101, or may be connected via a wireless connection to user system 101. In some examples, compensator 121 may be incorporated into microphone 122 or may be connected in the communication path for audio between microphone 122 and user system 101.

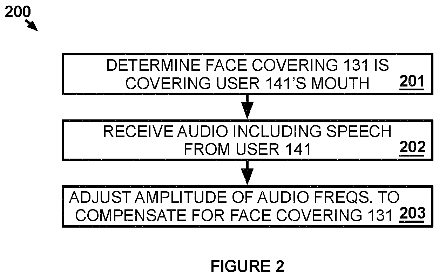

Figure 2 illustrates operation 200 to compensate for face coverings in captured audio. Operation 200 is performed by compensator 121 of user system 101 in this example. In other examples, operation 200 may be performed by a compensator in a system remote to user system 101, such as communication session system 401 in implementation 400 below. In operation 200, compensator 121 determines that a face covering (face covering 131 in this case) is positioned to cover the mouth of user 141 (201). Face covering 131 may be a mask, face shield, or other type of covering that, when positioned to cover user 141's mouth (and, often, user 141's nose), aims to prevent particles from being expelled from the mouth into the surrounding air or be inhaled from the surrounding air. By covering their mouth with face covering 131, user 141 has positioned material (e.g., cloth, paper, plastic in the case of a face shield, or other type of face covering material) between their mouth and microphone 122 through which sound generated by user 141's voice will travel.

Compensator 121 may determine that face covering 131 specifically is positioned over user 141's mouth (as opposed to another face covering), may determine a face covering of face covering 131's type (e.g., cloth mask, paper mask, plastic face shield, etc.) is positioned over user 141's mouth, or may simply determine that a face covering is positioned over user 141's mouth without additional detail. Compensator 121 may receive input from user 141 indicating that face covering 131 is being worn, may process video captured of user 141 to determine that user 141's mouth is covered by face covering 131 (e.g., may use facial recognition algorithms to recognize that user 141's mouth is covered), may recognize a particular attenuation pattern in audio of user 141 speaking that indicates a face covering is present, or may determine that a face covering is positioned over user 141's mouth in some other way.

Compensator 121 receives audio 111 that includes speech from user 141 (202). Audio 111 is received from microphone 122 after being captured by microphone 122. Audio 111 may be audio for transmitting on a communication session between user system 101 and another communication system (e.g., another user system operated by another user), may be audio for recording in a memory of user system 101 or elsewhere (e.g., a cloud storage system), or may be audio captured from user 141 for some other reason.

Since compensator 121 determined that face covering 131 is covering user 141's mouth, compensator 121 adjusts amplitudes of frequencies in audio 111 to compensate for face covering 131 (203). The presence of face covering 131 between user 141's mouth and microphone 122 attenuates the amplitudes of at least a portion of the frequencies in the sound generated by user 141's voice as the sound passes through face covering 131. As such, audio 111, which represents the sound as captured by microphone 122, has the amplitudes of corresponding frequencies attenuated relative to what the amplitudes would be had user 141 not been wearing a mask. Compensator 121 adjusts the respective amplitudes of the affected frequencies to levels (or at least closer to the levels) that the amplitudes would have been had user 141 not been wearing face covering 131. Compensator 121 may operate on an analog version of audio 111 or on a digitized version of audio 111. Compensator 121 may adjust the amplitudes in a manner similar to how an audio equalizer adjusts the power (i.e., amplitude) of frequencies in audio.

In some examples, the amounts in which certain frequencies should be adjusted may be predefined within compensator 121. In those examples, the predefined adjustment amounts may be based upon a "one size fits all" or "best fit" philosophy where the adjustments are predefined to account for attenuation caused by many different types of face coverings (e.g., cloth, paper, plastic, etc.). For instance, if a set of frequencies are typically attenuated by a range of amplitude amounts depending on face covering material, then the predefined adjustments may define an amount that is in the middle of that range. In some examples, the predefined adjustments may include amounts for specific types of face coverings if compensator 121 determined a specific type for face covering 131 above. For instance, the amount in which the amplitude for a set of frequencies are adjusted may be different in the predefined amounts depending on the type of face covering 131.

In other examples, compensator 121 may be trained to recognize amounts in which the amplitudes of frequencies are attenuated so that those frequencies can be amplified a proportionate amount to return the speech of user 141 to levels similar to those had face covering 131 not been present. Compensator 121 may be trained specifically to account for face covering 131, may be trained to account for a specific type face covering (e.g., trained for cloth, paper, etc.), may be trained to account for any type of face covering (e.g., the one size fits all approach discussed above), may be trained to account for different types of face coverings depending on what user 141 is determined to be wearing (e.g., trained to account for a cloth mask if user 141 is face covering 131 is cloth and trained to accept for a paper mask if user 141 is wearing a paper mask at a different time), may be trained specifically to account for user 141's speech, may be trained to account for multiple users speech, and/or may be trained in some other manner. In some cases, compensator 121 may analyze speech in audio from user 141 when no face covering is present over user 141's mouth to learn over time what to expect from user 141's speech levels (i.e., amplitudes at respective frequencies). Regardless of why type of face covering face covering 131 ends up being, compensator 121 may simply amplify frequencies in audio 111 to levels corresponding to what compensator 121 had learned to expect. In some cases, compensator 121 may be able to recognize that face covering 131 is present in the above step based on comparing the levels in audio 111 to those compensator 121 is expecting from user 141 without a mask.

Advantageously, adjusting the amplitudes of attenuated frequencies in audio 111 close to the levels expected if face covering 131 was not covering user 141's mouth will make speech from user 141 easier to comprehend while user 141 is wearing face covering 131. Thus, when played back by user system 101 or some other system (e.g., another endpoint on a communication session), even if user 141's voice does not quite sound exactly like it would if user 141 was not wearing face covering 131, user 141's speech is more comprehendible than it would be if the adjustment was never performed.

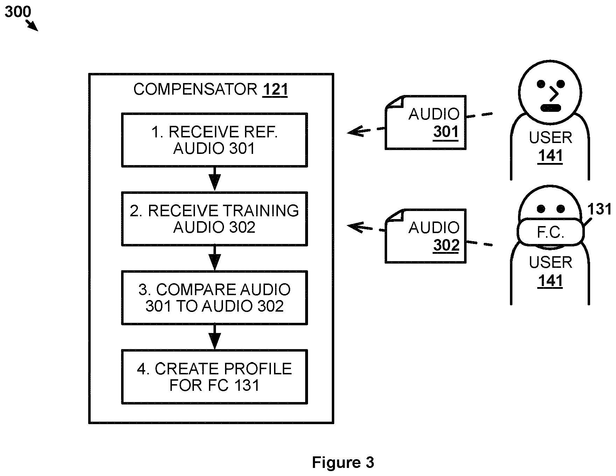

Figure 3 illustrates operational scenario 300 for compensating for face coverings in captured audio. Operational scenario 300 is an example of how compensator 121 may be explicitly trained to compensate for user 141 wearing face covering 131 to cover their mouth. In this example, compensator 121 receives, via microphone 122, reference audio 301 from user 141 at step 1 while user 141 is not wearing a face covering of any kind. Reference audio 301 includes speech from user 141 where user 141 speaks a script of words. Compensator 121 may provide the script to user 141 (e.g., direct user system 101 to display the words in the script to user 141) or user 141 may use something of their own. Compensator 121 then receives, via microphone 122, training audio 302 at step 2 while user 141 is wearing face covering 131 to cover their mouth. Training audio 302 includes speech from user 141 where user 141 speaks the same script of words that was used for reference audio 301. Compensator 121 may further direct user 141 to speak the words from the script in the same way (or as close to the same way as possible) user 141 spoke the words to produce reference audio 301 (e.g., the same volume, cadence, pace, etc.) to minimize the number of variables between reference audio 301 and training audio 302 outside of face covering 131 being present for training audio 302 and not for reference audio 301. Preferably, the script includes words that will capture user 141's full speech frequency range. While this example has the receipt of training audio 302 occur after receipt of reference audio 301, reference audio 301 may be received after training audio 302 in other examples.

Compensator 121 compares reference audio 301 to training audio 302 at step 3 to determine how much the frequencies of user 141's speech are attenuated in training audio 302 due to face covering 131. Since reference audio 301 and training audio 302 include speech using the same script, the frequencies included therein should have been spoken at similar amplitudes by user 141. Thus, the difference in amplitudes (i.e., attenuation) between frequencies in reference audio 301 and corresponding frequencies in training audio 302 can be assumed to be caused by face covering 131. Compensator 121 then uses the differences in amplitudes across at least the range of frequencies typical for human speech (e.g., roughly 125Hz to 8000Hz) to create a profile at step 4 that user 141 can enable when wearing face covering 131. The profile indicates to compensator 121 frequencies and amounts in which those frequencies should be amplified in order to compensate for user 141 wearing face covering 131 in subsequently received audio (e.g., audio 111).

In some examples, user 141 may similarly train compensator 121 while wearing different types of face coverings over their mouth. A separate profile associated with user 141 may be created for each type of face covering. Compensator 121 may then load, or otherwise access, the appropriate profile for the face covering being worn by user 141 after determining the type of face covering being worn. For example, user 141 may indicate that they are wearing a cloth mask and, responsively, compensator 121 loads the profile for user 141 wearing a cloth mask. In some examples, face covering profiles generated for user 141 may be stored in a cloud storage system. Even if user 141 is operating a user system other than user system 101, that other user system may load a profile from the cloud to compensate for user 141 wearing a face covering corresponding to the profile.

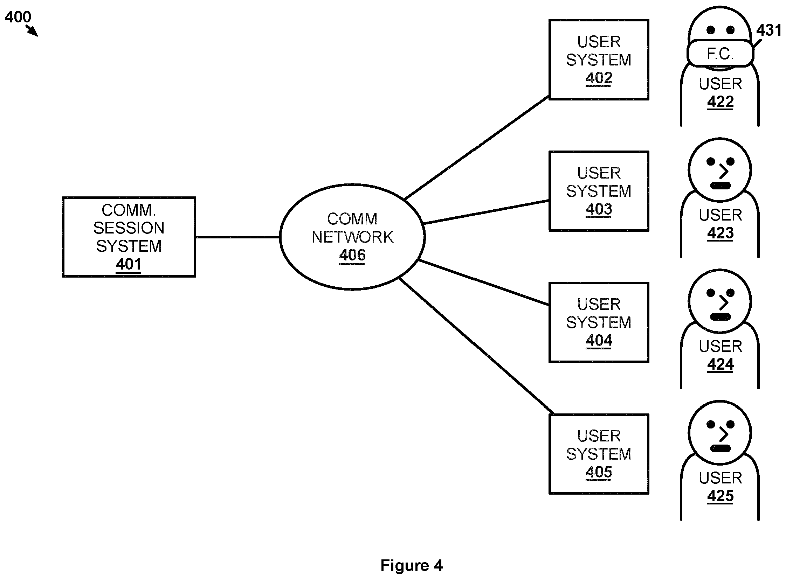

Figure 4 illustrates implementation 400 for compensating for face coverings in captured audio. Implementation 400 includes communication session system 401, user systems 402-405, and communication network 406. Communication network 406 includes one or more local area and/or wide area computing networks, including the Internet, over which communication session system 401 and user systems 402-405 communicate. User systems 402-405 may each comprise a telephone, laptop computer, desktop workstation, tablet computer, conference room system, or some other type of user operable computing device. Communication session system 401 may be an audio/video conferencing server, a packet telecommunications server, a web-based presentation server, or some other type of computing system that facilitates user communication sessions between endpoints. User systems 402-405 may each execute a client application that enables user systems 402-405 to connect to, and join communication sessions facilitated by, communication session system 401.

In operation, a real-time communication session is established between user systems 402-405, which are operated by respective users 422-425. The communication session enables users 422-425 to speak with one another in real time via their respective endpoints (i.e., user systems 402-405). Communication session system 401 includes a compensator that determines when a user is wearing a face covering and adjusts audio received from the user over the communication session to compensate for the attenuation caused by the face covering. The adjusted audio is then sent to others on the communication session. In this example, only user 422 is wearing a face covering. Thus, only audio of user 422 from user system 402 is adjusted by communication network 406 before sending to user systems 403-405 for playback to users 423-425, as described below. In other examples, one or more of users 423-425 may also be wearing a face covering and communication session system 401 may similarly adjust the audio received of those users as well.

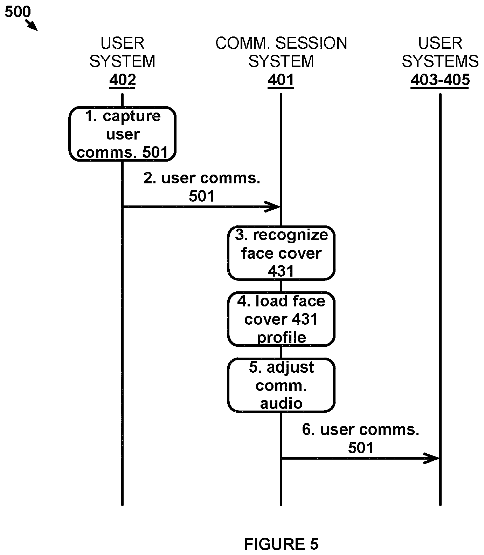

Figure 5 illustrates operational scenario 500 for compensating for face coverings in captured audio. In operational scenario 500, user system 402 captures user communications 501 at step 1 for inclusion on the communication session. User communications 501 at least includes audio captured of user 422 speaking but may also include other forms of user communications, such as video captured of user 422 contemporaneously with the audio and/or screen capture video of user system 402's display. User system 402 transmits user communications 501 to communication session system 401 at step 2 for distribution to user systems 403-405 over the communication session.

Communication session system 401 recognizes, at step 3, that user 422 is wearing face covering 431 when generating user communications 501 (i.e., when speaking). Communication session system 401 may recognize that user 422 is wearing face covering 431 from analyzing user communications 501. For example, communication session system 401 may determine that the amplitudes of frequencies in the audio of user communications 501 indicate a face covering is being worn or, if user communications 501 include video of user 422, communication session system 401 may use facial recognition algorithms to determine that user 422's mouth is covered by face covering 431. In alternative examples, user system 402 may provide an indication to communication session system 401 outside of user communications 501 that user 422 is wearing face covering 431. For example, the user interface of a client application executing on user system 402 may include a toggle that user 422 engages to indicate that face covering 431 is being worn. The user may indicate, or communication session system 401 may otherwise recognize, that face covering 431 specifically is being worn, that a face covering of face covering 431's type (e.g., cloth mask, paper mask, face shield, etc.) is being worn, or that a face covering is being worn regardless of type.

In this example, communication session system 401 stores profiles for face coverings associated with users. The profiles may be generated by communication session system 401 performing a training process similar to that described in operational scenario 300 or may be received from user systems performing training processes like that described in operational scenario 300. Communication session system 401 loads a profile associated with user 422 for face covering 431 at step 4. The profile may be for face covering 431 specifically or may be a profile for a face covering of face covering 431's type depending on how specific communication session system 401's recognition of face covering 431 was at step 3 or depending on how specific the profiles stored for user 422 are (e.g., the profiles may be stored for a particular mask or for a mask type). If no profile exists for particular face covering 431, then communication session system 401 may determine whether a profile exists for a face covering of the same type as face covering 431. If still no profile exists (e.g., user 422 may not have trained for the type of face covering), then communication session system 401 may use a default profile for the type of face covering or for face coverings in general. While the default profile is not tailored to the attenuations caused by face coverings for user 422 specifically, using the default profile to adjust audio in user communications 501 will likely result in improved speech comprehension during playback regardless.

Communication session system 401 adjusts the audio in user communications 501 at step 5 in accordance with the profile. In particular, the profile indicates amounts in which the amplitudes of respective frequencies in the audio should be amplified and communication session system 401 performs those amplifications in substantially real time so as to minimize latency of user communications 501 on the communication session. After adjusting the audio, communication session system 401 transmits user communications 501 to each of user systems 403-405 at step 6. Upon receipt of user communications 501, each of user systems 403-405 plays audio in user communications 501 to respective users 423-425. When each of users 423-425 hears the audio played, the audio should sound to them more like user 422 was not speaking through face covering 431 due to the adjustments made by communication session system 401.

In some examples, step 3 may be performed once and the profile determined at step 4 may be used for the remainder of the communication session. In other examples, communication session system 401 may determine later on in the communication session that user 422 is no longer wearing a face covering (e.g., may receive input from user 422 indicating that face covering 431 has been removed or may no longer detect face covering 431 in video captured of user 422). In those examples, communication session system 401 may stop adjusting the audio in user communications 501 because there is no longer a face covering for which to compensate. Similarly, should communication session system 401 recognize that a face covering, face covering 431 or otherwise, is put back on by user 422, then communication session system 401 may then reload a profile for that face covering and begin adjusting the audio again.

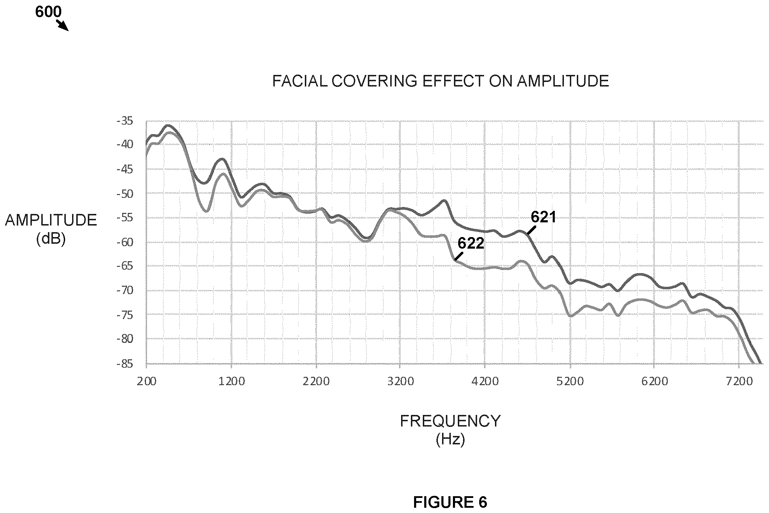

Figure 6 illustrates speech frequency spectrum graph 600 for compensating for face coverings in captured audio. Spectrum graph 600 is a graph of amplitudes in Decibels (dB) for frequencies in Hertz (Hz) for a range of frequencies common to human speech. Spectrum graph 600 includes a line representing reference audio 621 and a line representing training audio 622. Reference audio 621 is similar to reference audio 301 from above in that reference audio 621 includes speech received from a user while the user is not wearing a face covering. Likewise, training audio 622 is similar to training audio 302 from above in that training audio 622 includes speech received from the user while the user is wearing a face covering. As is clear from spectrum graph 600, the amplitudes in training audio 622 is lower almost across the board in comparison to the amplitudes in reference audio 621 and the amount in which the amplitudes are lower varies in a non-linear manner with respect to frequency.

The difference between reference audio 621 and training audio 622 at any same frequency may be used to indicate the amount in which audio should be adjusted at the corresponding frequency when the audio, like training audio 622, is received while the user is wearing a face covering. For instance, based on the information shown in spectrum graph 600, at 4200 Hz, the amplitude of received audio should be increased by roughly 7 dB while no amplification is necessary at 2000 Hz (i.e., reference audio 621 and training audio 622 overlap at that point). In some examples, rather than tracking amplitude adjustments for every possible frequency in the speech range, as seemingly possible based on the continuous lines representing reference audio 621 and training audio 622 on spectrum graph 600, the adjustment amounts may be divided into frequency sets each comprising a range of frequencies. The sets may be of consistent size (e.g., 100 Hz) or may be of varying size based upon frequency ranges having similar amplitude adjustment amounts. In an example of varying frequency ranges, one range may be 2000-2200 Hz corresponding to no change in amplitude while another range may be 4000-4600 Hz corresponding to a 7 dB change in amplitude, which represents a best fit change across all frequencies in that range, as can be visualized on spectrum graph 600 and may be determined via a best fit algorithm of the compensator. Other ranges with corresponding changes in amplitude would also correspond to the remaining portions of the speech frequency spectrum. In further examples, the frequency set that is adjusted may simply be all frequencies above a given frequency should be adjusted. For instance, based on spectrum graph 600, the compensator may determine that all frequencies above 3400 Hz should be amplified by 5 dB while frequencies below 3400 Hz should remain as is. Adjusting the frequencies in this manner may work well for a default profile where more specific adjustments are not determined for a particular user and face covering combination.

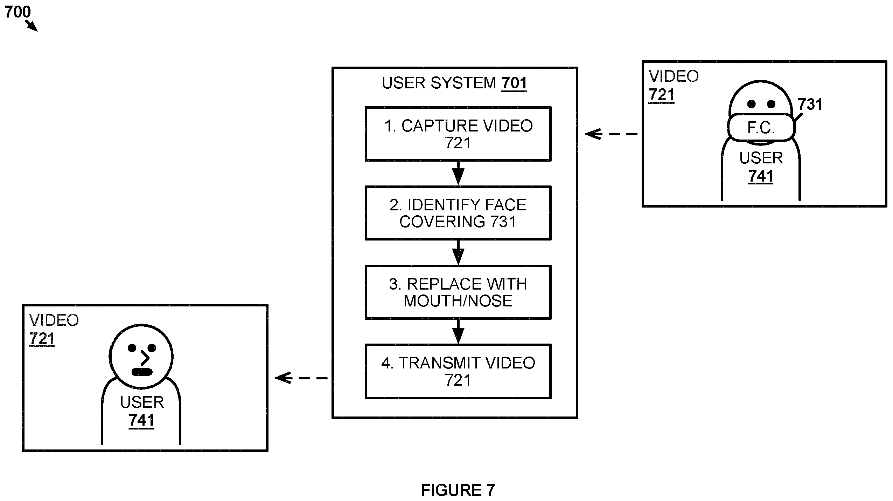

Figure 7 illustrates operational scenario 700 for compensating for face coverings in captured video. Operational scenario 700 involves user system 701 which is an example of user system 101 from above. A compensator similar to compensator 121 may direct user system 701 to perform the steps discussed below or some other hardware/software element of user system 701 may direct user system 701 instead. In this example, user 741 is operating user system 701 on a real-time video communication session with one or more other endpoints and captures video 721, which includes a video image of user 741, at step 1. In this example, user 741 is wearing face covering 731 in video 721 and user system 701 identifies that fact at step 2. User system 701 may identify face covering 731 by processing video 721 (e.g., using facial recognition) or may identify that user 741 is wearing face covering 731 in some other manner, such as a manner described in the above examples.

After detecting face covering 731, user system 701 edits video 721 at step 3 to remove face covering 731 and replace face covering 731 with a synthesized version of user 741's mouth, nose, cheeks, and any other element that is covered by face covering 731. An algorithm for performing the editing may be previously trained using video of user 741 without a face covering, which allows the algorithm to learn what user 741 looks like underneath face covering 731. The algorithm then replaces face covering 731 in the image of video 721 with an synthesized version of what the algorithm has learned to be the covered portion of user 741's face. In some examples, the algorithm may further be trained to synthesize mouth/facial movement consistent with user 741 speaking particular words so that user 741 appears in video 721 to be speaking in correspondence with audio captured of user 741 actually speaking on the communication session (e.g., audio that is captured and adjusted in the examples above). Similarly, the algorithm may be trained to make the synthesized portion of user 741's face emote in conjunction with expressions made by the portions of user 741's face that can be seen outside of face covering 731. In other examples, if the algorithm has not been trained to user 741 specifically, the algorithm may be able to estimate what the covered portion of user 741's face looks like based on other people used to train the algorithm and based on what the algorithm can see in video 721 (e.g., skin tone, hair color, etc.).

After editing video 721 to replace face covering 731, video 721 is transmitted over the communication session at step 4. Preferably, the above steps occur in substantially real time to reduce latency on the communication session. Regardless, when played at a receiving endpoint, video 721 includes video images of user 741 without face covering 731 being visible and, in its place, is a synthesized version of the portion of user 741's face that was covered by face covering 731. While video 721 is transmitted from user system 701 in this example, video 721 may be used for other purposes in other examples, such as posting on a video sharing service or simply saving to memory. Also, while user system 701 captures video 721, one or more of the remaining steps may be performed elsewhere, such as at a communication session system, rather than on user system 701 itself. In scenarios where both audio is adjusted in accordance with the above examples and video is edited in accordance with operational scenario 700, it should appear to a user viewing video 721 and listening to corresponding audio that user 741 is not wearing face covering 731. In some examples, operational scenario 700 may occur to compensate for face covering 731 in video while not also compensating for corresponding audio.

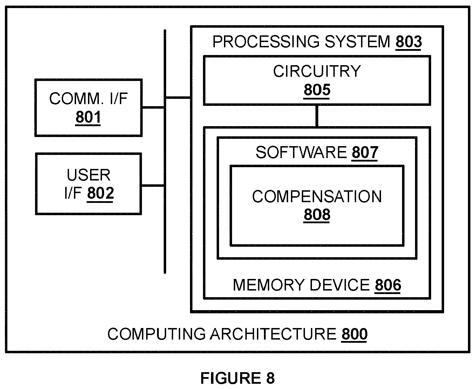

Figure 8 illustrates computing architecture 800 for compensating for face coverings in captured audio. Computing architecture 800 is an example computing architecture for user systems 101, 402-405, 701 and communication session system 401, although those systems may use alternative configurations. Computing architecture 800 comprises communication interface 801, user interface 802, and processing system 803. Processing system 803 is linked to communication interface 801 and user interface 802. Processing system 803 includes processing circuitry 805 and memory device 806 that stores operating software 807.

Communication interface 801 comprises components that communicate over communication links, such as network cards, ports, RF transceivers, processing circuitry and software, or some other communication devices. Communication interface 801 may be configured to communicate over metallic, wireless, or optical links. Communication interface 801 may be configured to use TDM, IP, Ethernet, optical networking, wireless protocols, communication signaling, or some other communication format - including combinations thereof.

User interface 802 comprises components that interact with a user. User interface 802 may include a keyboard, display screen, mouse, touch pad, or some other user input/output apparatus. User interface 802 may be omitted in some examples.

Processing circuitry 805 comprises microprocessor and other circuitry that retrieves and executes operating software 807 from memory device 806. Memory device 806 comprises a computer readable storage medium, such as a disk drive, flash drive, data storage circuitry, or some other memory apparatus. In no examples would a storage medium of memory device 806 be considered a propagated signal. Operating software 807 comprises computer programs, firmware, or some other form of machine-readable processing instructions. Operating software 807 includes compensation module 808. Operating software 807 may further include an operating system, utilities, drivers, network interfaces, applications, or some other type of software. When executed by processing circuitry 805, operating software 807 directs processing system 803 to operate computing architecture 800 as described herein.

In particular, compensation module 808 directs processing system 803 to determine that a face covering is positioned to cover the mouth of a user of a user system. Compensation module 808 also directs processing system 803 to receive audio that includes speech from the user and adjust amplitudes of frequencies in the audio to compensate for the face covering.

The descriptions and figures included herein depict specific implementations of the claimed invention(s). For the purpose of teaching inventive principles, some conventional aspects have been simplified or omitted. In addition, some variations from these implementations may be appreciated that fall within the scope of the invention. It may also be appreciated that the features described above can be combined in various ways to form multiple implementations. As a result, the invention is not limited to the specific implementations described above, but only by the claims and their equivalents.

## Claims

1. A method comprising:
determining (201) that a face covering is positioned to cover the mouth of a user of a user system;
receiving (202) audio that includes speech from the user; and
adjusting (203) amplitudes of frequencies in the audio to compensate for the face covering, wherein the amplitudes are adjusted based on reference amplitudes of the frequencies in reference audio that includes reference speech from one or more reference users with an uncovered mouth.

2. The method of claim 1, comprising:
after adjusting the frequencies, transmitting the audio over a communication session between the user system and another user system.

3. The method of claim 1, wherein adjusting the amplitudes of the frequencies comprises:
amplifying the frequencies based on attenuation to the frequencies caused by the face covering, wherein the attenuation indicates that a first set of the frequencies should be amplified by a first amount and a second set of the frequencies should be amplified by a second amount.

4. The method of claim 1, comprising:
receiving the reference audio, wherein the one or more reference users include the user while the mouth is not covered by the face covering; and
comparing the reference audio to the audio to determine an amount in which the frequencies have been attenuated by the face covering.

5. The method of claim 4, comprising:
receiving training audio that includes training speech from the user while the mouth is covered by the face covering, wherein the training speech and the reference speech include words spoken by the user from a same script.

6. An apparatus comprising:
one or more computer readable storage media;
a processing system operatively coupled with the one or more computer readable storage media; and
program instructions stored on the one or more computer readable storage media that, when read and executed by the processing system, direct the processing system to:
determine (201) that a face covering is positioned to cover the mouth of a user of a user system;
receive (202) audio that includes speech from the user; and
adjust (203) amplitudes of frequencies in the audio to compensate for the face covering, wherein the amplitudes are adjusted based on reference amplitudes of the frequencies in reference audio that includes reference speech from one or more reference users with an uncovered mouth.

7. The apparatus of claim 6, wherein the program instructions direct the processing system to:
after adjusting the frequencies, transmit the audio over a communication session between the user system and another user system.

8. The apparatus of claim 6, wherein to adjust the amplitudes of the frequencies, the program instructions direct the processing system to:
amplify the frequencies based on attenuation to the frequencies caused by the face covering, wherein the attenuation indicates that a first set of the frequencies should be amplified by a first amount and a second set of the frequencies should be amplified by a second amount.

9. The apparatus of claim 6, wherein the program instructions direct the processing system to:
receive the reference audio, wherein the one or more reference users include the user while the mouth is not covered by the face covering; and
compare the reference audio to the audio to determine an amount in which the frequencies have been attenuated by the face covering.

10. The apparatus of claim 9, wherein the program instructions direct the processing system to:
receive training audio that includes training speech from the user while the mouth is covered by the face covering, wherein the training speech and the reference speech include words spoken by the user from a same script.

## Patentansprüche

1. Verfahren, aufweisend:
Feststellen (201), dass eine Gesichtsabdeckung so positioniert ist, dass sie den Mund eines Benutzers eines Benutzersystems bedeckt;
Empfangen (202) von Audio, das Sprache vom Benutzer enthält; und
Anpassen (203) von Amplituden von Frequenzen im Audio, um die Gesichtsabdeckung zu kompensieren, wobei die Amplituden basierend auf Referenzamplituden der Frequenzen in Referenzaudio eingestellt werden, das Referenzsprache von ein oder mehr Referenzbenutzern mit einem unbedeckten Mund enthält.

2. Verfahren nach Anspruch 1, aufweisend:
nach dem Einstellen der Frequenzen, Übertragen des Audios über eine Kommunikationssitzung zwischen dem Benutzersystem und einem anderen Benutzersystem.

3. Verfahren nach Anspruch 1, wobei das Einstellen der Amplituden der Frequenzen aufweist:
Verstärken der Frequenzen basierend auf der Dämpfung der Frequenzen, die durch die Gesichtsabdeckung verursacht wird, wobei die Dämpfung anzeigt, dass ein erster Satz der Frequenzen um einen ersten Betrag verstärkt werden sollte und ein zweiter Satz der Frequenzen um einen zweiten Betrag verstärkt werden sollte.

4. Verfahren nach Anspruch 1, aufweisend:
Empfangen des Referenzaudios, wobei die ein oder mehr Referenzbenutzer den Benutzer enthalten, während der Mund nicht durch die Gesichtsabdeckung bedeckt ist; und
Vergleichen des Referenzaudios mit dem Audio, um eine Menge zu bestimmen, in der die Frequenzen durch die Gesichtsabdeckung gedämpft wurden.

5. Verfahren nach Anspruch 4, aufweisend:
Empfangen von Trainingsaudio, das Trainingssprache vom Benutzer enthält, während der Mund durch die Gesichtsabdeckung bedeckt ist, wobei die Trainingssprache und die Referenzsprache Wörter beinhalten, die vom Benutzer aus einem gleichen Skript gesprochen werden.

6. Vorrichtung, aufweisend:
ein oder mehr computerlesbare Speichermedien;
ein Verarbeitungssystem, das operativ mit den ein oder mehr computerlesbaren Speichermedien gekoppelt ist; und
Programmanweisungen, die auf den ein oder mehr computerlesbaren Speichermedien gespeichert sind, die, wenn sie vom Verarbeitungssystem gelesen und ausgeführt werden, das Verarbeitungssystem anweisen zum:
Feststellen (201), dass eine Gesichtsabdeckung so positioniert ist, dass sie den Mund eines Benutzers eines Benutzersystems bedeckt;
Empfangen (202) von Audio, das Sprache vom Benutzer enthält; und
Anpassen (203) von Amplituden von Frequenzen im Audio, um die Gesichtsabdeckung zu kompensieren, wobei die Amplituden basierend auf Referenzamplituden der Frequenzen in Referenzaudio eingestellt werden, das Referenzsprache von ein oder mehr Referenzbenutzern mit einem unbedeckten Mund enthält.

7. Vorrichtung nach Anspruch 6, wobei die Programmanweisungen das Verarbeitungssystem anweisen, um:
nach dem Einstellen der Frequenzen den Audio über eine Kommunikationssitzung zwischen dem Benutzersystem und einem anderen Benutzersystem zu übertragen.

8. Vorrichtung nach Anspruch 6, wobei zum Einstellen der Amplituden der Frequenzen die Programmanweisungen das Verarbeitungssystem anweisen, um: die Frequenzen basierend auf der Dämpfung der Frequenzen, die durch die Gesichtsabdeckung verursacht wird, zu verstärken, wobei die Dämpfung anzeigt, dass ein erster Satz der Frequenzen um einen ersten Betrag verstärkt werden sollte und ein zweiter Satz der Frequenzen um einen zweiten Betrag verstärkt werden sollte.

9. Vorrichtung nach Anspruch 6, wobei die Programmanweisungen das Verarbeitungssystem anweisen zum:
Empfangen des Referenzaudios, wobei die ein oder mehr Referenzbenutzer den Benutzer beinhalten, während der Mund nicht durch die Gesichtsabdeckung bedeckt ist; und
Vergleichen des Referenzaudios mit dem Audio, um eine Menge zu bestimmen, in der die Frequenzen durch die Gesichtsabdeckung gedämpft wurden.

10. Vorrichtung nach Anspruch 9, wobei die Programmanweisungen das Verarbeitungssystem anweisen zum:
Empfangen von Trainingsaudio, das Trainingssprache vom Benutzer enthält, während der Mund durch die Gesichtsabdeckung bedeckt ist, wobei die Trainingssprache und die Referenzsprache Wörter beinhalten, die vom Benutzer aus einem gleichen Skript gesprochen werden.

## Revendications

1. Procédé consistant à :
déterminer (201) qu'un couvre-visage est positionné de manière à couvrir la bouche d'un utilisateur d'un système d'utilisateur ;
recevoir (202) de l'audio qui inclut une expression verbale de l'utilisateur ; et
ajuster (203) des amplitudes de fréquences dans l'audio pour compenser le couvre-visage, les amplitudes étant ajustées sur la base d'amplitudes de référence des fréquences dans de l'audio de référence qui inclut une expression verbale de référence d'un ou plusieurs utilisateurs de référence avec leur bouche non couverte.

2. Procédé selon la revendication 1, consistant à :
après avoir ajusté les fréquences, transmettre l'audio via une session de communication entre le système d'utilisateur et un autre système d'utilisateur.

3. Procédé selon la revendication 1, dans lequel l'ajustement des amplitudes de fréquences consiste à :
amplifier les fréquences sur la base d'une atténuation des fréquences causée par le couvre-visage, l'atténuation indiquant qu'un premier ensemble de fréquences devrait être amplifié d'une première quantité et qu'un deuxième ensemble de fréquences devrait être amplifié d'une deuxième quantité.

4. Procédé selon la revendication 1, consistant à :
recevoir l'audio de référence, lesdits un ou plusieurs utilisateurs de référence incluant l'utilisateur tandis que la bouche n'est pas couverte par le couvre-visage ; et
comparer l'audio de référence à l'audio pour déterminer une quantité dont les fréquences ont été atténuées par le couvre-visage.

5. Procédé selon la revendication 4, consistant à :
recevoir de l'audio d'entraînement qui inclut une expression verbale d'entraînement de l'utilisateur tandis que la bouche est couverte par le couvre-visage, l'expression verbale d'entraînement et l'expression verbale de référence incluant des mots prononcés par l'utilisateur à partir d'un même script.

6. Appareil comprenant :
un ou plusieurs supports de stockage lisibles par ordinateur ;
un système de traitement couplé de manière fonctionnelle auxdits un ou plusieurs supports de stockage lisibles par ordinateur ; et
des instructions de programme stockées sur lesdits un ou plusieurs supports de stockage lisibles par ordinateur qui, une fois lues et exécutées par le système de traitement, conduisent le système de traitement à :
déterminer (201) qu'un couvre-visage est positionné de manière à couvrir la bouche d'un utilisateur d'un système d'utilisateur ;
recevoir (202) de l'audio qui inclut une expression verbale de l'utilisateur ; et
ajuster (203) des amplitudes de fréquences dans l'audio pour compenser le couvre-visage, les amplitudes étant ajustées sur la base d'amplitudes de référence des fréquences dans de l'audio de référence qui inclut une expression verbale de référence d'un ou plusieurs utilisateurs de référence avec leur bouche non couverte.

7. Appareil selon la revendication 6, dans lequel les instructions de programme conduisent le système de traitement à :
après avoir ajusté les fréquences, transmettre l'audio via une session de communication entre le système d'utilisateur et un autre système d'utilisateur.

8. Appareil selon la revendication 6, dans lequel, pour ajuster les amplitudes de fréquences, les instructions de programme conduisent le système de traitement à :
amplifier les fréquences sur la base d'une atténuation des fréquences causée par le couvre-visage, l'atténuation indiquant qu'un premier ensemble de fréquences devrait être amplifié d'une première quantité et qu'un deuxième ensemble de fréquences devrait être amplifié d'une deuxième quantité.

9. Appareil selon la revendication 6, dans lequel les instructions de programme conduisent le système de traitement à :
recevoir l'audio de référence, lesdits un ou plusieurs utilisateurs de référence incluant l'utilisateur tandis que la bouche n'est pas couverte par le couvre-visage ; et
comparer l'audio de référence à l'audio pour déterminer une quantité dont les fréquences ont été atténuées par le couvre-visage.

10. Appareil selon la revendication 9, dans lequel les instructions de programme conduisent le système de traitement à :
recevoir de l'audio d'entraînement qui inclut une expression verbale d'entraînement de l'utilisateur tandis que la bouche est couverte par le couvre-visage, l'expression verbale d'entraînement et l'expression verbale de référence incluant des mots prononcés par l'utilisateur à partir d'un même script.
